# EUROPÄISCHE PATENTSCHRIFT

(11) **EP 1 249 031 B1**
(45) Veröffentlichungstag und Bekanntmachung des Hinweises auf die Patenterteilung: **18.08.2004**
(21) Anmeldenummer: 01913504.5
(22) Anmeldetag: 12.01.2001
(51) Int. Cl.: H01J 37/153

(54) **ELEKTRONENOPTISCHER KORREKTOR ZUR BESEITIGUNG DER BILDFEHLER DRITTER ORDNUNG**
ELECTRON-OPTICAL CORRECTOR FOR ELIMINATING THIRD-ORDER ABERRATIONS
CORRECTEUR OPTOELECTRONIQUE POUR L'ELIMINATION D'ABERRATIONS D'IMAGE DU TROISIEME ORDRE

(30) Priorität: 14.01.2000 DE 10001277
(43) Veröffentlichungstag der Anmeldung: 16.10.2002
(73) Patentinhaber: LEO Elektronenmikroskopie GmbH, 73447 Oberkochen (DE)
(72) Erfinder: ROSE, Harald, 64287 Darmstadt (DE)
(74) Vertreter: Pöhner, Wilfried, Dr.
(86) Internationale Anmeldenummer: PCT/DE2001/000102
(87) Internationale Veröffentlichungsnummer: WO 2001/052301

(56) Entgegenhaltungen:
- US-A- 2 919 381
- US-A- 4 389 571
- CREWE A V: "The sextupole corrector. I. Algebraic calculations" OPTIK, 1984, WEST GERMANY, Bd. 69, Nr. 1, 1984, Seiten 24-29, XP002168451 ISSN: 0030-4026
- CREWE A V: "A system for the correction of axial aperture aberrations in electron lenses" OPTIK, 1982, WEST GERMANY, Bd. 60, Nr. 3, 1982, Seiten 271-281, XP002168452 ISSN: 0030-4026

## Beschreibung

Die Erfindung betrifft einen elektronenoptischen Korrektor zur Beseitigung der Bildfehler dritter Ordnung, wie öffnungsfehler, Bildfeldwölbung, außeraxialer Astigmatismus und frei ist von außeraxialer Koma dritter Ordnung sowie der Verzeichnung dritter Ordnung ebenso wie vom Farbfehler erster Ordnung ersten Grades mit einem zur Mittelebene symmetrischen Aufbau in Richtung der geraden optischen Achse mit in Richtung des Strahlenganges zunächst einem Hexapol (S₁) der Länge l₁, dann eine Rundlinse (R₁) , als nächstes ein Hexapol (S₂) von der Länge l₂.

Die Leistungsfähigkeit elektronenoptischer Systeme, unter denen im Sinne dieser Erfindung auch mit Ionen abbildende Systeme zu verstehen sind, wird durch ihre Bildfehler begrenzt, wobei in Abhängigkeit vom konkreten Verwendungszweck und dem Umfang der bereits vorgenommenen Korrekturen bestimmte Bildfehler für die Begrenzung der Leistung verantwortlich sind, deren Beseitigung einen erheblichen Fortschritt bei der Verbesserung elektronenoptischer Systeme bedeutet. Eine systematische Unterteilung und Zusammenfassung der Bildfehler ist möglich in die axialen Bildfehler, die durch die in den beiden Schnitten von der optischen Achse in der Gegenstandsebene ausgehenden Fundamentalbahnen bestimmt werden, den außeraxialen Bildfehlern, welche ihrerseits von den außerhalb der optischen Achse in der Gegenstandsebene ausgehenden Fundamentalbahnen abhängig sind, sowie durch die chromatischen Fehler, die nur bei unterschiedlichen Geschwindigkeiten der abbildenden Elektronen auftreten. Bei vergrößernden elektronenoptischen Systemen, wie sie in der Elektronenmikroskopie Verwendung finden, steht die Beseitigung der axialen Bildfehler zur Steigerung der Leistungsfähigkeit im Vordergrund. Bei verkleinernden elektronenoptischen Systemen, wie sie in der Lithographie zum Beschreiben von Objekten mit Hilfe von Elektronenstrahlen eingesetzt werden, ist die Beseitigung außeraxialer Bildfehler entscheidend.

Ziel ist stets, die aus den abbildenden Linsensystem sowie dem Korrektor bestehende Anordnung in ihrer Gesamtheit so aufzubauen und einzustellen, daß die die Leistungsfähigkeit begrenzenden Bildfehler des Gesamtsystemes beseitigt oder doch wesentliche minimiert werden, wobei dem Korrektor die Aufgabe zufällt, einerseits durch negative Bildfehlerkoeffizienten eine Eliminierung bzw. zumindest Verringerung zu erreichen und andererseits keine Erhöhung nachteiliger Bildfehlerkoeffizienten hervorzurufen.

Aus Optik 69 Nr.1 (1984) 24-29 ist es bereits bekannt zur Korrektur elektronenoptischer Bildfehler an Rundlinsen zwei Hexapole einzusetzen. Diese Korrekturelemente werden auch zur Eliminierung der sphärischen Aberration erster Ordnung eingesetzt (Optik 60 Nr.3 (1982) 271-281).

Aus der US-A-4,389,571 ist ein elektronenoptischer Korrektor zur Beseitigung von Bildfehlern dritter Ordnung bekannt, der zwei Hexapole mit einer dazwischen befindlichen Rundlinse aufweist, die in ihrer Gesamtheit zwischen zwei weiteren Rundlinsen angeordnet sind.

Aufgabe vorliegender Erfindung ist die Schaffung eines elektronenoptischen Korrektors mit dessen Hilfe neben dem Farbfehler erster Ordnung und ersten Grades sämtliche Bildfehler dritter Ordnung, wie öffnungsfehler, Bildfeldwölbung, außeraxialem Astigmatismus, außeraxialer Koma sowie Verzeichnung beseitigt werden, derart daß kein zusätzlicher außeraxialer erzeugt wird.

Gelöst wird diese Aufgabe erfindungsgemäß dadurch, daß sich daran eine Rundlinse (R₂) anschließt und hieran schließlich ein dritter Hexapol (S₃) von der Stärke des Hexapoles (S₁) sowie dessen doppelter Länge l₃=2l₁ folgt, wobei der Abstand der beiden Rundlinsen (Rᵢ) gleicher Stärke 2f der Brennweite beträgt im Brennpunkt zwischen beiden Rundlinsen (R₁, R₂) der Hexapol (S₂) angeordnet ist und der Abstand der Rundlinse zum ersten Hexapol (S₁) so gewählt ist, daß die der Korrektormitte zugeordnete Ebene des (S₁) im vorderen Brennpunkt der nachgeordneten Rundlinse zu liegen kommt und die Mitte der Hexapole (S₂) und (S₃) in der Brennebene der Rundlinsen (R₁, R₂) angeordnet ist und schließlich sich zwei weitere Rundlinsen (R₃, R₄) und Hexapole (S₄, S₅) anschließen, die symmetrisch zur Mittelebene Zₘ des Hexapoles (S₃) aufgebaut sind.

Zur Realisierung des notwendigen teleskopischen Gaußschen Strahlenganges beträgt der Abstand benachbarter Rundlinsen jeweils 2f, wobei f die Brennweite der Rundlinse bedeutet. Die Hexapole S₂, S₄ und S₃ sind mit ihrer Mitte jeweils im Brennpunkt der Rundlinsen anzuordnen. Die Hexapole S₁ und S₅ werden so zugeordnet, daß ihre jeweils innere Ebene im Brennpunkt der Rundlinse zu liegen kommt. Um keine Fehler zweiter Ordnung entstehen zu lassen, ist die Stärke der Hexapollinsen S₁, S₃ und S₅ jeweils gleich groß. Zudem werden S₂ =S₄ eingestellt, die jedoch in ihrer Stärke von S₁, S₃ und S5 völlig unabhängig wählbar sind. Allerdings ist stets erforderlich eine Symmetrie im Hinblick auf die Mittelebene Zₘ im Aufbau und Einstellung des Korrektors zu gewährleisten.

Zur Beseitigung des Öffnungsfehlers und der Bildfeldwölbung als auch des außeraxialen Astigmatismus (alle Fehler der dritten Ordnung) stehen die Stärke der Hexapole S₁ und S₂ als frei und unabhängig voneinander wählbare Parameter zur Verfügung. Durch entsprechende Einstellung lassen sich zwei der vorgenannten Bildfehler im Gesamtsystem eliminieren. Für die Zwecke der Lithographie steht im Vordergrund, den außeraxialen Astigmatismus als auch die Bildfeldwölbung zu beseitigen. Der Öffnungsfehler dritter Ordnung des Korrektors ist zwar negativ und führt zu einer Reduzierung des Gesamtfehlers, wird im allgemeinsten Falle jedoch nicht zu Null. Durch geeignete räumliche Anordnung im Gesamtsystem und entsprechender Abstandswahl zu den benachbarten Linsen läßt sich für eine bestimmte Vergrößerung erreichen, daß auch der Öffnungsfehler dritter Ordnung des Gesamtsystemes kompensiert wird.

Neben der Beseitigung der vorgenannten Bildfehler ist der Korrektor selbst im übrigen frei von Verzeichnung und Koma dritter Ordnung sowie vom außeraxialen Farbfehler erster Ordnung ersten Grades, so daß bei einem Einbau des Korrektors in ein entsprechend fehlerfreies elektronenoptisches System das Gesamtsystem im Hinblick auf diese Fehler ebenfalls fehlerfrei bleibt. Für eine Vergrößerung ungleich 1 ergeben theoretische Überlegungen, daß ein System frei von außeraxialer Koma und Verzeichnung aus mindestens vier Linsen bestehen muß.

Die entscheidenden Vorteile des vorgeschlagenen. Korrektors bestehen zunächst darin bei entsprechender Einstellung und räumlicher Anordnung den Öffnungsfehler, die Bildfeldwölbung und den außeraxialen Astigmatismus (sämtliche der dritten Ordnung) so einzustellen, daß das Gesamtsystem fehlerfrei wird, sondern darüberhinaus auch weitere Bildfehler, nämlich die Verzeichnung dritter Ordnung, die außeraxiale Koma und der Farbfehler erster Ordnung und ersten Grades durch den Korrektor, da selbst fehlerfrei, hinsichtlich des Gesamtsystemes keine Erhöhung erfährt.

Im allgemeinsten Fall werden die Hexapole stets im gleichen Schnitt relativ zueinander ausgerichtet sein. Im Falle der Verwendung von Magnetlinsen ergibt sich durch das magnetische Feld ein anisotroper (azimutaler Anteil); der zu einer Bilddrehung Anlaß gibt. Zur Fehlerbeseitigung erfolgt eine Drehung der Schnitte des Hexapoles S₂ (und den im gleichen Schnitt liegenden S₄) relativ zu den ebenfalls in einen gemeinsamen Schnitt ausgerichteten Hexapole S₁, S₃ und S₅. Der Drehwinkel bestimmt sich durch die Größe des durch das Magnetfeld bestimmten anisotropen Anteils.

Die Drehung der Hexapole kann unter Beibehaltung der mechanischen Ausrichtung auf elektrostatischen Wege dann erfolgen, wenn zur Erzeugung des Hexapolfeldes ein Zwölfpol Verwendung findet, der eine Drehung der Schnitte um einen beliebigen Winkel durch entsprechende Umpolung der Elektroden erlaubt. Es wird demnach möglich, nach dem Einbau der Zwölfpole das Hexapolfeld durch entsprechende Änderung der Polung um den gewünschten Winkel zu drehen.

Der bisher vorgeschlagene Korrektor beseitigt die Bildfehler bis zur dritten Ordnung. In einer besonders bevorzugten Weiterbildung werden zwei dieser Korrektive hintereinander in Reihe angeordnet und über ein Rundlinsendublett miteinander optisch verbunden. Dabei beträgt der Abstand der beiden Rundlinsen 2f und der Abstand des letzten Hexapoles des ersten Korrektors zur ersten Rundlinse sowie den Abstand zwischen zweiter Rundlinse und dem anschließenden Hexapol ebenfalls gleich der Brennweite f. Durch eine solche Verknüpfung erhält man in beiden Korrektoren eine antisymmetrischen Strahlenverlauf der zu einer gegenseitigen Kompensation der Fehler vierter Ordnung der beiden Einzelkorrektive führt. Das System hat dann, da die verbleibenden Rundlinsen frei sind von Fehler vierter Ordnung, nur noch Fehler fünfter und höherer Ordnung. Einen Korrektor mit diesen optischen Eigenschaften wird als Doppelanastigmat bezeichnet.

Bevorzugte Verwendung findet der erfindungsgemäß vorgeschlagene Korrektor in einem verkleinernden elektronenoptischen System wie es in der Lithographie Verwendung findet und die dazu genutzt werden bestimmte durch eine Maske definierte Strukturen durch das elektronenoptische System zu verkleinern und auf den in der Bildebene befindlichen Kristall (Wafer) durch die auftreffenden Elektroden einzuprägen und zu beschreiben. Es geht um die Schaffung elektronischer Bauelemente und integrierter Schaltkreise mit möglichst geringen Abmessungen, wobei die elektronenoptischen Systeme im Vergleich mit lichtoptischen Abbildungen aufgrund ihrer wesentlich geringeren Wellenlänge den Vorteil haben wesentlich feinere Strukturen wiedergeben zu können. Hierbei wird der Korrektor nach der hinter der Gegenstandsebene befindlichen Projektionslinse in den Strahlengang gebracht und ausgangsseitig - ggf. über Zwischenschalten einer Transferlinse - über ein Objektiv in der Bildebene den Eingriffsteil (Wafer) beschreibt. Der Begriff Objektivlinse ist weit zu fassen und kann aus einer aus mehreren Linsen zusammengesetzten Anordnung bestehen. Der vorgeschlagene Korrektor hat gerade den Vorteil, die die Leistungsfähigkeit von elektronenoptisch verkleinernden Abbildungssystemen begrenzenden Bildfehler beseitigen zu können. Eine wesentliche Verbesserung der Abbildungsqualität steht demnach zu erwarten.

Weitere Einzelheiten, Merkmale und Vorteile der Erfindung lassen sich dem nachfolgenden Beschreibungsteil entnehmen, in dem anhand der Zeichnung ein erfindungsgemäßer Korrektor beschrieben wird.
Es zeigen:

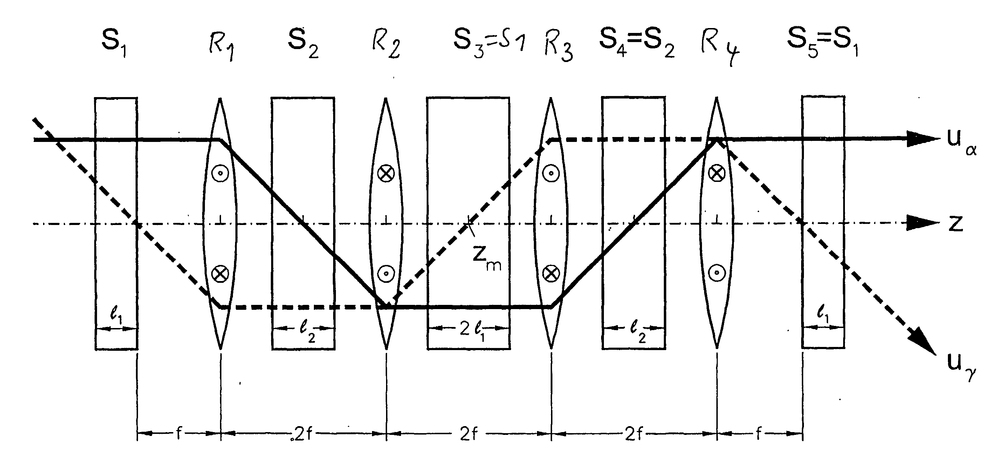

- **Figur 1**: einen Schnitt entlang der optischen Achse und Wiedergabe der Gaußschen Fundamentalbahnen.

Die zeichnerische Wiedergabe ist in prinzipieller Darstellung gehalten. Die Hexapole sind hierbei mit Sᵢ, ihre Länge mit lᵢ und die Rundlinsen mit Rᵢ bezeichnet. Der Korrektor ist wie folgt aufgebaut:

Einlaßseitig befindet sich der erste Hexapol S₁ von der Länge l₁. Hieran schließen sich das aus den Rundlinsen R₁ und R₂ bestehende Rundlinsendublett an, wobei die Brennweite beider Rundlinsen R₁ und R₂ übereinstimmt und ihr Abstand gleich 2f, wobei f die Brennweite ist, gewählt wurde, so daß das Rundlinsenduplett in seiner Gesamtheit einen teleskopischen Strahlengang erzeugt. Zwischen den beiden Rundlinsen R₁, R₂ ist in der Brennebene der weitere Hexapol S₂ von der Länge l₂ angeordnet. Der einlaßseitige erste Hexapol S₁ befindet sich in einem solchen Abstand, daß dessen innere Ebene im Brennpunkt der nachfolgenden Rundlinse zu liegen kommt. Der in Richtung des strahlenganges nachfolgende Hexapol S₃ ist in seiner Stärke gleich dem Hexapol S₁ gewählt, jedoch von dem gegenüber doppelter Länge l₃ = 2l₁. Die räumliche Zuordnung erfolgt in der Weise, daß die Mittelebene des Hexapoles S3 in die Brennebene Zₘ der Rundlinse zu liegen kommt.

Der weitere Aufbau des Korrektors in Richtung des Strahlenganges ist symmetrisch zu dieser Mittelebene Zₘ, so daß sowohl im Hinblick auf die räumliche Anordnung als auch auf die gewählte Polstärke auf die bisherigen Ausführungen zur Vermeidung von Wiederholungen Bezug genommen werden kann.

Der beschriebene Korrektor besitzt zwei frei wählbare Parameter, nämlich die Stärke des Hexapoles S₁ (und damit auch die des Hexapoles S₃ und S₅) als auch die Stärke des Hexapoles S₂ (und somit auch die des Hexapoles S₄). Diese beiden Parameter erlauben es zwei der nachfolgend genannten drei Bildfehler, nämlich Bildfeldwölbung, außeraxialer Astigmatismus und Öffnungsfehler dritter Ordnung, beliebig einzustellen, und zwar derart, daß eine Kompensation zweier dieser Bildfehler eintritt. Wie bereits beschrieben läßt sich der dritte Fehler (beschrieben anhand des öffnungsfehlers dritter Ordnung) durch entsprechende Wahl der geometrischen Parameter und insbesondere des Abstandes ebenfalls in der gewünschten Weise beeinflussen, so daß eine weitgehende Kompensation des dritten Bildfehlers möglich ist.

## Patentansprüche

1. Elektronenoptischer Korrektor zur Beseitigung der Bildfehler dritter Ordnung, wie Öffnungsfehler, Bildfeldwölbung, außeraxialer Astigmatismus und frei ist von außeraxialer Koma dritter Ordnung sowie der Verzeichnung dritter Ordnung ebenso wie vom Farbfehler erster Ordnung ersten Grades mit einem zur Mittelebene symmetrischen Aufbau in Richtung der geraden optischen Achse mit in Richtung des Strahlenganges zunächst einem ersten Hexapol (S₁) der Länge l₁, dann eine Rundlinse (R₁), als nächstes ein zweiter Hexapol (S₂) von der Länge l₂, **dadurch gekennzeichnet, daß** sich daran eine Rundlinse (R₂) anschließt und hieran schließlich ein dritter Hexapol (S₃) von der Stärke des ersten Hexapoles (S₁) sowie dessen doppelter Länge l₃=2l₁ folgt,
wobei der Abstand der beiden Rundlinsen (Rᵢ) gleicher Stärke 2f der Brennweite beträgt und im Brennpunkt zwischen beiden Rundlinsen (R₁, R₂) der zweite Hexapol (S₂) angeordnet ist und der Abstand der Rundlinse zum ersten Hexapol (S₁) so gewählt ist, daß die der Korrektormitte zugeordnete Ebene des ersten Hexapols (S₁) im vorderen Brennpunkt der nachgeordneten Rundlinse zu liegen kommt und die Mitte der zweiten und dritten Hexapole (S₂) und (S₃) in der Brennebene der Rundlinsen (R₁, R₂) angeordnet ist und schließlich sich zwei weitere Rundlinsen (R₃, R₄) und Hexapole (S₄, S₅) anschließen, die symmetrisch zur Mittelebene Zₘ des dritten Hexapoles S₃ aufgebaut sind.

2. Korrektor nach Anspruch 1, **dadurch gekennzeichnet, daß** die Stärken des ersten und zweiten Hexapols (S₁, S₂) jeweils so gewählt sind, daß der außeraxiale Astigmatismus als auch die Bildfeldwölbung des Gesamtsystems beseitigt werden und der Abstand zu den benachbarten Linsen des Gesamtsystemes so gewählt ist, daß der Öffnungsfehler dritter Ordnung bis hin zur Kompensation beeinflußbar ist.

3. Korrektor nach Anspruch 1 oder 2, **dadurch gekennzeichnet, daß** der Schnitt der zweiten und viertn Hexapole (S₂, S₄) gegenüber den durch die anderen Hexapole (erster, dritter, fünfter Hexapol) (S₁, S₃, S₅) gebildeten Schnittes um die optische Achse azimutal gedreht ist.

4. Korrektor nach Anspruch 3, **dadurch gekennzeichnet, daß** die Hexapole in einem aus 12 Elektroden oder Polschuhen bestehenden Zwölfpolelement erzeugt sind.

5. Elektronenoptischer Korrektor nach einem der vorhergehenden Ansprüche, **dadurch gekennzeichnet, daß** zwei der oben genannten Korrektoren über ein Rundlinsendublett hintereinander angeordnet sind, wobei der Abstand der beiden Rundlinse das Zweifache von deren Brennweite entspricht und der Abstand des letzten Hexapols des ersten Korrktors zur ersten Rundlinse und ebenso der Abstand der zweiten Rundlinse des Rundlinsendubletts zum ersten Hexapol des zweiten Korrektors jeweils der Brennweite f der Rundlinse entspricht.

6. Verwendung eines elektronenoptischen Korrektors nach einem der vorhergehenden Ansprüche in einem verkleinernden elektronenoptischen System, insbesondere der Lithographie, bei der sich in der Gegenstandsebene die abzubildende Maske und in der Bildebene ein Wafer befindet, mit einer in Richtung des Strahlenganges hinter der Gegenstandsebene befindliche Projektionslinse und einer der Bildebene vorgeschalteten Objektivlinse, **dadurch gekennzeichnet, daß** in Richtung des Strahlenganges nach der Projektionslinse der Korrektor in den Strahlengang eingebracht ist.

7. Verwendung eines elektronenoptischen Korrektors nach einem der vorhergehenden Ansprüche in einem verkleinernden elektronenoptischen System, insbesondere der Lithographie bei der sich in der Gegenstandsebene die abzubildende Maske und in der Bildebene ein Wafer befindet, mit einer in Richtung des Strahlenganges hinter der Gegenstandsebene befindliche Projektionslinse und einer der Bildebene vorgeschalteten Objektivlinse, **gekennzeichnet durch** eine Transferlinse zwischen Korrektor und Objektivlinse.

## Claims

1. Electron-optical corrector for eliminating third-order aberrations, such as spherical aberrations, field curvature and off-axis astigmatism, said corrector being devoid of third-order off-axis coma, third-order distortion and first-order chromatic aberrations of the first degree, the corrector having a construction which is symmetrical about the central plane in the direction of the linear optical axis, a hexapole (S₁) of length l₁ being first positioned in the direction of the beam path, followed by a circular lens R₁, a hexapole (S₂) of length l₂ **characterised in that** this is followed by a circular lens (R₂), which is followed by a third hexapole (S₃) with the same strength as the first hexapole (S₁) and twice the length l₃ = 2I₁ thereof, the separation of the two circular lenses (Rᵢ) of the same strength being 2f of the focal length, the second hexapole (S₂) being positioned in the principal focus between the two circular lenses (R₁, R₂), and the distance of the circular lens from the first hexapole (S₁) being chosen such that the plane of the first hexapole (S₁), which is assigned to the corrector centre, comes to lie in the front principal focus of the circular lens that is positioned downstream, and the centre of the second and third hexapoles (S₂) and (S₃) is positioned in the focal plane of the circular lenses (R₁, R₂) and this is finally followed by two further circular lenses (R₃, R₄) and hexapoles (S₄, S₅), which are set up symmetric-ally to the centre plane Zₘ of the third hexapole (S₃).

2. Corrector according to Claim 1, **characterised in that** the strengths of the first and second hexapoles (S₁, S₂) are in each case chosen so as to eliminate the off-axis astigmatism, as well as the field curvature of the entire system, and the distance from the adjacent lenses of the entire system is chosen so that the third-order spherical aberration can be influenced to the extent of compensation.

3. Corrector according to Claim 1 or 2, **characterised in that** the section of the second and fourth hexapoles (S₂, S₄) is azimuthally rotated about the optical axis with respect to the section formed by the other hexapoles (first, third, fifth hexapole) (S₁, S₃, S₅).

4. Corrector according to Claim 3, **characterised in that** the hexapoles are generated in a twelve-pole element comprising 12 electrodes or pole shoes.

5. Electron-optical corrector according to one of the preceding claims, **characterised in that** two of the aforementioned correctors are positioned in series by means of a circular lens doublet, the distance between the two circular lenses corresponding to twice their focal length, and the distance from the last hexapole of the first corrector to the first circular lens, and also the distance from the second circular lens of the circular lens doublet to the first hexapole of the second corrector in each case corresponding to the focal length f of the circular lens.

6. Use of an electron-optical corrector according to one of the preceding claims in a size-reducing electron-optical system, in particular lithography, wherein the mask to be imaged is located in the object plane and a wafer is located in the image plane, comprising a projection lens located downstream of the object plane in the direction of the beam path and an objective lens located upstream of the image plane, **characterised in that** the corrector is inserted in the beam path downstream, in the direction of the beam path, of the projection lens.

7. Use of an electron-optical corrector according to one of the preceding claims in a size-reducing electron-optical system, in particular lithography, wherein the mask to be imaged is located in the object plane and a wafer is located in the image plane, comprising a projection lens located downstream of the object plane in the direction of the beam path and an objective lens located upstream of the image plane, **characterised by** a transfer lens between the corrector and objective lens.

## Revendications

1. Correcteur optoélectronique destiné à la correction des aberrations optiques de troisième ordre telles que l'aberration d'ouverture, la courbure de champ et l'astigmatisme extra-axial, exempt de coma extra-axial de troisième ordre, de distorsion de troisième ordre et d'aberration chromatique de premier ordre et de premier degré, présentant une structure symétrique par rapport au plan médian dans le sens de l'axe optique rectiligne, et comportant dans l'ordre un premier hexapôle (S₁) de longueur l1, une lentille sphérique (R₁), puis un deuxième hexapôle (S₂) de longueur l₂, **caractérisé en ce que** ces éléments sont suivis d'une lentille sphérique (R₂) elle-même finalement suivie d'un troisième hexapôle (S₃) de la même puissance que le premier hexapôle (S₁) et de longueur égale au double de la longueur de celui-ci dernier l₃ = 2 l₁, la distance entre les deux lentilles sphériques (Rᵢ) de même puissance étant égale à 2f, f étant la distance focale, le deuxième hexapôle (S₂) étant situé dans le foyer entre les deux lentilles sphériques (R₁, R₂), la distance entre la lentille sphérique et le premier hexapôle (S₁) étant choisie de manière à ce que le plan du premier hexapôle (S₁) tourné vers le milieu du correcteur se situe dans le foyer antérieur de la lentille qui lui succède et que le milieu du deuxième et du troisième hexapôle (S₂) et (S₃) se trouve respectivement dans le plan focal des lentilles sphériques (R₁, R₂), et le système total étant finalement suivi de deux autres lentilles sphériques (R₃, R₄) et de deux autres hexapôles (S₄, S₅) disposés symétriquement par rapport au plan médian Zₘ du troisième hexapôle (S₃).

2. Correcteur optoélectronique selon la revendication 1, **caractérisé en ce que** la puissance du premier et du deuxième hexapôle (S₁, S₂) est choisie de manière à pouvoir supprimer l'astigmatisme extra-axial et la courbure de champ du système total, et la distance jusqu'aux lentilles avoisinantes du système total de manière à pouvoir influencer, voir compenser l'aberration d'ouverture de troisième ordre.

3. Correcteur optoélectronique selon la revendication 1 ou 2, **caractérisé en ce que** la coupe du deuxième et du quatrième hexapôle (S₂, S₄) subit une rotation azimutale autour de l'axe optique, par rapport à la coupe formée par les autres hexapôles (le premier, le troisième et le cinquième).

4. Correcteur optoélectronique selon la revendication 3, **caractérisé en ce que** les hexapôles sont créés dans un élément à 12 pôles composé de 12 électrodes ou pièces polaires.

5. Correcteur optoélectronique selon l'une des revendications précédentes, **caractérisé en ce que** deux des correcteurs cités plus haut sont disposés l'un derrière l'autre et sont optiquement reliés par un doublet de lentilles sphériques, la distance entre les deux lentilles sphériques étant égale au double de leur distance focale et la distance du dernier hexapôle du premier correcteur à la première lentille sphérique ainsi que la distance de la deuxième lentille sphérique du doublet au premier hexapôle du deuxième correcteur étant égale à la distance focale f de la lentille sphérique.

6. Utilisation d'un correcteur optoélectronique selon l'une des revendications précédentes dans un système optoélectronique modèle réduit, notamment en lithographie où le masque à reproduire se trouve dans le plan de l'objet et une plaquette dans le plan de l'image, équipé d'une lentille de projection située en arrière du plan de l'objet dans le sens de la trajectoire du faisceau, et d'une lentille d'objectif en avant du plan de l'image, **caractérisé en ce que** le correcteur est placé dans la trajectoire du faisceau, derrière la lentille de projection dans le sens de la trajectoire du faisceau.

7. Utilisation d'un correcteur optoélectronique selon l'une des revendications précédentes dans un système optoélectronique modèle réduit, notamment en lithographie où le masque à reproduire se trouve dans le plan de l'objet et une plaquette dans le plan de l'image, équipé d'une lentille de projection située en arrière du plan de l'objet dans le sens de la trajectoire du faisceau, et d'une lentille d'objectif en avant du plan de l'image, **caractérisé en ce que** une lentille de transfert est placée entre le correcteur et la lentille de l'objectif.
